(19) Europäisches Patentamt
European Patent Office
Office européen des brevets

(11) Publication number: 0 030 857
B1

(12) EUROPEAN PATENT SPECIFICATION

(45) Date of publication of patent specification: 14.08.85

(51) Int. Cl.⁴: **H 03 K 23/66,** H 03 K 23/58

(21) Application number: 80304498.1

(22) Date of filing: 12.12.80

# (54) Programmable counter circuit.

(30) Priority: 17.12.79 JP 163796/79

(43) Date of publication of application:
24.06.81 Bulletin 81/25

(45) Publication of the grant of the patent:
14.08.85 Bulletin 85/33

(84) Designated Contracting States:
DE FR GB NL

(56) References cited:

Patents Abstracts of Japan, vol. 2, no. 79, 23. Juni 1978, page 3298E78
Patentams Abstracts of Japan, vol. 2, no. 22, 14. February 1978, page 11447E77

(73) Proprietor: FUJITSU LIMITED
1015, Kamikodanaka Nakahara-ku
Kawasaki-shi Kanagawa 211 (JP)

(72) Inventor: Asami, Fumitaka
No. 27, Fujimidai 1-chome
Kunitachi-shi Tokyo, 186 (JP)
Inventor: Takagi, Osamu
No. 8-11-5-408, Ohjima
Kohtoh-ku Tokyo, 136 (JP)

(74) Representative: Sunderland, James Harry et al
HASELTINE LAKE & CO Hazlitt House 28
Southampton Buildings Chancery Lane
London WC2A 1AT (GB)

EP 0 030 857 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to a programmable counter circuit.

A programmable counter which operates as an N-step counter with a variable frequency dividing ratio N has a counter circuit, formed by a multistage connection of flip-flops, and a loading circuit for writing an initial value (N) in the counter circuit. Figure 1 shows an example of a conventional programmable counter circuit indicated generally by CNT, in which a plurality of flip-flop stages $P_{D1}$, $P_{D2}$, ... are cascade-connected; the flip-flop $P_{D1}$ of the first stage being supplied with a clock signal $F_{IN}$; the flip-flops $P_{D2}$, $P_{D3}$, ... of the following stages being each supplied with the output from the immediately preceding stage; and bits $DL_1$, $DL_2$, $DL_3$, ... forming initial values are respectively loaded into the flip-flops of the individual stages. The bits $DL_1$, $DL_2$, $DL_3$, ... are bits of binary numbers and are given the numeric values of first, second, fourth, eighth, ... digits of a binary number in a sequential order. For loading the initial values $DL_1$, $DL_2$, ... in the counter circuit CNT, the numeric values of the bits $DL_1$, $DL_2$, ... are set up by digital switches or latch circuits and then a load signal LOAD is applied to a common line $L_1$, by which the numeric values $DL_1$, $DL_2$, ... are respectively input to the flip-flop $P_{D1}$, $P_{D2}$, ... The clock counting is down-counting. Assuming, for example, that the initial values $DL_1$, $DL_2$, etc are "000100...", that is "8" in decimal notation, "8" is set by loading in the counter and counted down to 7, 6, ... by down-counting of the clock signal $F_{IN}$, and when the count value reaches "0", "8" is again set in the counter; namely, in this case, the counter serves as an 8-step counter (e.g. has a frequency dividing ratio of 8). By setting an initial value "20" with the bits $DL_1$, $DL_2$, ... set to "0010100..." and performing counting as mentioned above, the counter functions as a 20-step counter. (e.g. has a frequency dividing ratio of 20). In this way, a desired counter can be formed.

Basically a load signal generator may be one that generates a load signal LOAD when the count value of the counter circuit CNT becomes zero. In a case where the counter circuit CNT is counted down to "0" and it is detected by a gate circuit that outputs $Q_1$, $Q_2$, $Q_3$, ... $Q_{12}$ of the flip-flops $P_{D1}$, $P_{D2}$, $P_{D3}$, ... $P_{D12}$ are all "0" and the detected output is directly used as the load signal LOAD, when the initial value bits $DL_1$, $DL_2$, ... are loaded into only some of the flip-flops $P_{D1}$, $P_{D2}$, ... by loading in response to the load signal, the above condition for load signal generation is removed substantially immediately (there is a slight time lag in the loading of the bits to the respective flip-flops) and the load signal LOAD disappears, so that the initial values can not be loaded in the remaining flip-flops. To improve on this, it is common practice in the art to employ a signal generator LDG such as is shown in Figure 3 which is commonly referred to as an early decoder or look ahead circuit. This circuit comprises a specific count value detector circuit DET employing NOR gates $NOR_1$ to $NOR_4$ and NAND gates $NAND_1$ to $NAND_4$ and a shift register SHR employing D flip-flops $DFF_1$ to $DFF_3$. The detector circuit DET is one in which $Q$ or $\bar{Q}$ outputs from the counter circuit CNT are selectively applied to each gate to derive from the gate $NAND_4$ of the last stage the following output Ⓗ:

$$Ⓗ = Q_1 + Q_2 + \bar{Q}_3 + Q_4 + \ldots + Q_{12}.$$

Accordingly, in the detector DET of this example the output Ⓗ is "0" when $Q_1 = Q_2 = Q_4 \sim Q_{12} = 0$ and $Q_3 = 1$, that is, when the counter value is "4", and this output Ⓗ=0 is applied as a detection signal for the specific count value "4" to the shift register SHR. The shift register SHR has input thereto the output from the gate $NAND_4$, using the same clock signal $F_{IN}$ as the counter circuit CNT, and then after shifting for three clock signals and, accordingly when the count value of the counter circuit CNT has reached "1", it generates the load signal LOAD. With this system, each flip-flop is initialised (i.e. each flip-flop of the counter has loaded therein a bit of an initial value N) in response to the load signal and even if the output from the NAND gate $NAND_4$ is made high by the initialisation (i.e. even if the loading of initial value bits into the counter causes the output Ⓗ of $NAND_4$ to change to "1"), since it is the shift register SHR that outputs the load signal and since it will not change its state (after initialisation) for at least one clock signal, the load signal will not disappear for at least one clock period (despite the fact that Ⓗ has changed to "1"); namely, the load signal will be produced until the count value "0" is reached.

In such a programmable counter, as the number of stages of flip-flops increases, the load signal line $L_1$ becomes longer; especially in a MOS circuit, the capacitance of the load signal line $L_1$ increases to make the waveform of the load signal transmitted over the signal line $L_1$ dull or indefinite, introducing the possibility of an erroneous operation.

The dullness of the wavefrom can be avoided by applying the load signal to a waveform shaping circuit. The circuit arrangement therefor is shown in Figure 2. In the illustrated example, a buffer BUF formed by a series connection of two inverters is shown to be inserted between load terminals of every other pair of consecutive flip-flops. With such an arrangement, the load signal is applied only to the first stage flip-flop $P_{D1}$ and a buffer BUF connected thereto and each of the buffers drives a flip-flop of a succeeding stage and a succeeding buffer connected thereto, so that the load on the load signal generator LDG is greatly alleviated and the dullness or indefiniteness of the waveform is shaped by each buffer and hence does not become critical. With this arrangement, however, if operating frequency is increased, i.e. if clock signal frequency of the counter is increased, the load

circuit cannot follow up the increase in operating frequency although each flip-flop is operable, presenting the problem that the highest operating frequency is limited.

Delays in signal propagation by the buffers accumulate to produce a large delay in signal propagation at terminating parts of the counter and, as a result of this, a plurality of load signals can occur, making loading inaccurate. Accordingly, in the circuit of Figure 2 the highest operating frequency depends on the delay provided by the load circuit; therefore, an extensive improvement cannot be expected of this circuit though it slightly improves on the circuit of Figure 1. The generation of a plurality of load signals will hereinbelow be further described with reference to Figures 4 and 5.

Figure 4 is a waveform diagram explanatory of the operation of the programmable counter shown in Figure 2. In Figure 4, and Figures 5, A to G indicate waveforms occurring on lines A to G in Figure 3. For Figure 4 it is taken that $DL_3=DL_6=1$ and that the other DL bits are "0"; namely, the initial value is "36". Assuming that a low level of the output Ⓗ from the gate $NAND_4$ is produced upon occurrence of a second clock signal $F_{IN}$ in Figure 2 (a count of "4" is detected), a low-level load signal is generated after the occurrence of three further clock signals and the initial values $DL_1$, $DL_2$, . . . are loaded into the flip-flops $P_{D1}$, $P_{D2}$, . . . in a sequential order each loading being delayed from the last by a signal propagation delay time $\tau_1$ (of a buffer). Upon loading of the initial value $DL_1$, the Q of flip-flop $PD_1$ is returned to a low level although it should be high-level, and the NAND gate $NAND_4$ provides a low level output $H_2$ (in response to the detection of another count of "4") other than its original low level output $H_1$ but this is immediately restored by the lowering of the output G down to low level, as indicated by $G_1$ (upon loading of $DL_3$), so that loading does not take place twice.

In more detail, in a case in which an initial value of 36 is loaded operations are as follows:—

(a) when the detector circuit DET detects count "4", Ⓗ goes to a low value (see $Q_1$, $Q_2$, $Q_3$, and Ⓗ in Figure 4).

(b) After three further clock periods, when the count becomes "1", LOAD goes to a low value for one clock period (see LOAD in Fig. 4). Ⓗ returns to high value when count "4" disappears.

(c) Simultaneously, $Q_1$ goes to a low value ("0") which *cuts off early* the count "1" (see the third, narrow, pulse of $Q_1$ in Figure 4).

This means that the counter provides all "0" outputs with LOAD at a low level.

(d) Delay time $\tau_1$ later $Q_2$ is loaded with "0" and $Q_3$ is loaded with "1"—with LOAD still at low level.

(e) In response to loading of $Q_3$ with "1", F changes from high level to low level and G changes from low level to high level (to begin $G_1$).

Although G changes to high level at this time, Ⓗ remains at high level because LOAD is still at low level.

(f) Next, however, LOAD returns to high level, and consequently Ⓗ goes to low level, to begin $H_2$ (see Ⓗ in Figure 4).

(g) Loading of $Q_4$ and $Q_5$ with "0" produces no change in Ⓗ.

However loading of $Q_6$ with '1' (at timing of $LD_3$) causes F to change from low level to high level, and causes G to change from high level to low level, to end $G_1$.

(h) The change of G to low level changes Ⓗ to high level, to end $H_2$.

(i) Consequently, $H_2$ is a pulse of a short duration insufficient to trigger the shift register SHR, so a second LOAD signal is not produced.

Thus, in the case where the initial value is not a certain special value, the inventors have determined that a normal operation can be maintained even if operating frequency is a little high. However, the inventors have determined that in a case in which loading of such an initial value that $DL_3=1$ and a high-order bit becomes "1", e.g. $DL_{12}$ see $Q_{12}$ in Figure 5, is required, while the loading signal is being transmitted to the flip-flop $P_{D12}$, "1" is loaded in the flip-flop $P_{D3}$ and there can occur the state in which the outputs from the remaining flip-flops are all "0". Since this corresponds to a count value "4", the NAND gate $NAND_4$ yields a low-level output $H_2$ and after three clock signals the shift register SHR produces a load signal L' again.

In this case, when an initial value such that $DL_3=1$ and $DL_{12}=1$ is loaded, operations corresponding to steps (a) to (f) above are unchanged but operations corresponding to steps (g) to (i) above are as follows:—

(g)' loading of $Q_4$ to $Q_{11}$ with "0" produces no change in Ⓗ.

However, loading of $Q_{12}$ with "1" (at timing of $LD_6$) causes F to change from low level to high level, and causes G to change from high level to low level, to end $G_1$.

(h)' The change of G to low level changes Ⓗ to high level, to end $H_2$, but much later than $H_2$ is ended in Fig. 4,

(i)' Consequently, $H_2$ in Figure 5 is a pulse of sufficient duration to trigger SHR to produce second LOAD signal LOAD' three clock pulse later.

According to the present invention there is provided a programmable counter circuit in which, for loading an initial value, a load signal is applied from a load signal generator via a load signal line to each flip-flop stage of a counter which serves as an N-step counter dependent on the initial value to be loaded, and in which the load signal generator comprises a detector circuit for detecting a specified count value occurring a little before loading of the initial value into the counter circuit is to be effected, and a shift register to which an output provided from the detector circuit upon detection of the specified value is delivered and through which that output is shifted in response to clock signals, the same as those employed for driving the counter circuit, and which generates the load signal at the

moment at which initial value loading of the counter circuit is to be effected, characterised in that the load signal is applied by buffer circuitry comprising a plurality of waveform-shaping buffers distributed along the load signal line, and that a load control circuit is provided which sends out a signal for preventing the delivery of the said output from the detector circuit to the shift register for the duration of the load signal and at least until the loading of a digit of the initial value into the counter circuit making a count value higher than said specified count value.

An embodiment of the present invention can provide a programmable counter circuit having the merits of a counter circuit of the type having buffers inserted in the load signal line but which is free from its disadvantages.

In an embodiment of the present invention accurate loading of a programmable counter can be ensured.

In an embodiment of the present invention the counter operation of a programmable counter can be speeded up.

In an embodiment of the present invention the operating frequency of a programmable counter can be increased to the vicinity of the operational limit of flip-flops forming the counter.

Reference is made, by way of example, to the accompanying drawings, in which:—

Figure 1 is a block diagram illustrating a conventional programmable counter;

Figure 2 is a block diagram illustrating a programmable counter of a type in which buffers are inserted in a load signal line;

Figure 3 is a block diagram illustrating a prior art load signal generator circuit;

Figure 4 is a waveform diagram explanatory of the operation of the programmable counter of Figure 2 combined with the circuit of Figure 3, illustrating a case in which a number to be loaded is not a certain specific value;

Figure 5 is a waveform diagram, similar to Figure 4, illustrating a case in which data to be loaded is "1" in $DL_3$ and in a high-order bit ($DL_{12}$ in this example);

Figure 6 is a block diagram illustrating a load signal generator circuit in accordance with an embodiment of the present invention;

Figure 7 is a waveform diagram explanatory of a programmable counter circuit of the present invention which is a combination of the circuits of Figures 2 and 6;

Figure 8 is a circuit diagram illustrating specific examples of each of D type flip-flops $DFF_1$ to $DFF_3$ in Figure 6; and

Figure 9 is a circuit diagram illustrating a specific example of each of flip-flops $P_{D1}$ to $P_{D13}$ in Figure 6; and

Figure 10 is a circuit diagram illustrating a specific example of a flip-flop $P_{D14}$ in Figure 6.

Figure 6 shows principle parts of an embodiment of the present invention, that is, an improved load signal generator circuit LDG. The present invention can provide a programmable counter by a combination of this load generator circuit and the counter circuit CNT of Figure 2. A specific count value detector circuit DET and a shift register SHR in Figure 6 are the same as those used in Figure 3 and, in this embodiment, a load control circuit LCT is added. The load control circuit LCT is a dummy counter which has two bit flip-flops $P_{D13}$ and $P_{D14}$. A $\bar{Q}$ output $\overline{Q5}'$ of the flip-flop $P_{D14}$ is connected to one input of the NAND gate $NAND_4$ to set limits on a period during which the detector circuit DET can apply a detected output Ⓗ to the shift register SHR; namely, for the duration of the load signal LOAD and a certain period of time subsequent thereto the NAND gate $NAND_4$ is closed to hold the output Ⓗ high-level forcibly (not by the output G from the preceding stage of DET).

The flip-flop $P_{D13}$ of the first stage of the load control circuit LCT is supplied with outputs $Q_3$ and $\bar{Q}_3$ from the flip-flop $P_{D3}$ of the counter circuit CNT. The flip-flop $P_{D13}$ is identical in construction with the flip-flops $P_{D1}$, $P_{D2}$, ... of the counter circuit CNT and inverts its output upon each application of a clock signal ($Q_3$ and $\bar{Q}_3$ serve as clock signals). The flip-flop $P_{D14}$ at the output stage has its input circuit specially arranged and, when loaded with an initial value, produces an output "1" and inverts the output to "0" upon application of one clock signal (from $P_{D13}$), thereafter retaining the output "0" (until loaded with another initial value). Reference character $V_{DD}$ indicates a power supply for loading an initial value "1" into the flip-flops $P_{D13}$ and $P_{D14}$. The timing of loading of the initial value is the timing of the load signal LOAD for the flip-flop $P_{D14}$ and the timing of $LD_1$ for the flip-flop $P_{D13}$ (see Figures 4 and 5) but this may alternatively be the timing of a further delayed signal such as $LD_2$. With such an arrangement, as shown in Figure 7 (which shows an example of loading "1" in $Q_3$ and $Q_{12}$ as is the case for Figure 5), when the load signal $\overline{LOAD}$ becomes "0", the outputs $Q_5'$ and $\overline{Q_5}'$ immediately become "1" and "0", respectively, to operate on the NAND gate $NAND_4$ from the moment of generation of the load signal $\overline{LOAD}$ preventing the application of a low-level signal from the NAND gate $NAND_4$ to the shift register SHR. A period LDI during which the output $Q_5'$ is "1" is a load signal inhibit period. Next, at the timing $LD_1$ the flip-flop $P_{D13}$ is loaded with "1" and this state is retained until the outputs $Q_3$ and $\bar{Q}_3$ from the flip-flop $P_{D3}$ of the counter CNT vary. When the outputs $Q_3$ and $\overline{Q_3}$ serving as clock signals vary, the flip-flop $P_{D13}$ is inverted to render its output $Q_4'$ low-level and $\bar{Q}_4'$ high-level. Accordingly, the flip-flop $P_{D14}$ is inverted by the next clock signal to make its output $\bar{Q}_5'$ high-level to open the NAND gate $NAND_4$, deriving therefrom an output which is dependent on its inputs G and $\bar{Q}_1$. In this way, in the present circuit the output from the NAND gate $NAND_4$ is made high-level forcibly for a certain period of time to inhibit the generation of a second load signal.

In Figure 6, in comparison with Figure 3, the third input (bottom input in the Figures) to $NAND_4$ is derived from the load control circuit LCT, rather

than from the LOAD signal as in Figure 3. In Figure 3, the LOAD signal, supplied to the $NAND_4$, can be understood to prevent Ⓗ from going to low level whilst LOAD is low level (see steps (b) to (f) above). In Figure 6, Ⓗ is prevented from going to low level whilst $\overline{Q}'_5$ is low level.

As mentioned above, $P_{D13}$ of LCT is identical with flip-flops of the counter circuit CNT. It will be noted that, as shown in Figures 4, 5 and 7, the flip-flops are triggered by the rising edge of a clock signal. Also as mentioned above, $P_{D14}$ is so structured as to invert upon application of a clock signal thereto, then to retain the inverted state until again loaded with an initial value.

Outputs of flip-flop $PD_3$ of the counter circuit provide clock signals for $P_{D13}$, and outputs of $P_{D13}$ provide clock signals for $P_{D14}$.

When flip-flops $P_{D13}$ and $P_{D14}$ are loaded with initial values in response to LOAD and $LD_1$, since $\overline{Q}'_5=0$, Ⓗ is prevented from going to low level. $\overline{Q}_5'$ changes to 1 only upon receipt of a clock signal (rising edge) from $P_{D13}$. $P_{D13}$ is inverted in response to a change of $Q_3$ (output of $PD_3$) from 0 to 1 (i.e. a rising edge of a clock signal for $P_{D13}$). Similarly, $P_{D14}$ is inverted in response to a change of $Q_4'$ from 0 to 1.

Thus, a change of $Q_3$ from 0 to 1 will invert the initial value (1) of $Q_4'$ to 0; and a subsequent change of $Q_3$ from 0 to 1 will again invert $Q_4'$, to 1, to invert $Q_5'$ and $\overline{Q}_5'$ to thereafter allow Ⓗ to go to low level. That is, a second 0→1 transition of $Q_3$, after initial value loading, ends the load inhibit period.

It will be seen that such a second transition of $Q_3$, during counting down of the counter, cannot occur for a number of clock periods. Thus, the load inhibit period extends beyond the duration of the LOAD signal for a time sufficient to prevent generation of a signal LOAD' as seen in Figure 5.

The period of inhibition need only be a period until the output from the NAND gate $NAND_4$ is made high-level by a bit "1" of the initial value to be loaded and this period need not be long. Accordingly, the clock signal for the flip-flop $P_{D13}$ can be derived from the output of the flip-flop of any relatively preceding stage of the counter. When this clock signal is obtained from the flip-flop of a stage near the last stage of the counter, the value N of the N-step counter cannot be made small. For example, when the outputs $Q_3$ and $\overline{Q}_3$ are used as described above, if the counter circuit has a 12-bit configuration, the frequency dividing ratio (the number of steps which the counter can count) is within the range 16 to 4095; similarly, if the outputs $Q_4$ and $\overline{Q}_4$ were used, the frequency dividing ratio (the number of steps which the counter could count) ranges from 32 to 4095. The clock signal for the flip-flop $P_{D13}$ is selected, taking this into account. This is also related to the number of stages of the load control circuit; namely, the application of the outputs $Q_3$ and $\overline{Q}_3$ to a first one of the two stages of flip-flops is equivalent to the application of the outputs $Q_4$ and $\overline{Q}_4$ to one of two flip-flops of one stage.

Figure 8 illustrates a specific circuit arrangement for each of the D flip-flops $DFF_1$ to $DFF_3$; Figure 9 illustrates a specific circuit arrangement of each of the flip-flops $P_{D1}$ to $P_{D13}$; and Figure 10 illustrates a specific circuit arrangement of the flip-flop $P_{D14}$. Since they are known circuit arrangements which are formed of C-MOS inverters and transfer gates, no detailed description will be given. The flip-flops $P_{D1}$ to $P_{D13}$ each feed back their output $Q_n$ to an invert input terminal, so that flip-flop state is inverted upon each application of a clock signal $CK_N$. In contrast thereto, since the flip-flop $P_{D14}$ has no such feedback route and has one of its inputs connected to a high potential power supply $V_{DD}$ and the other input connected to a low potential power supply $V_{SS}$, it yields an output "1" upon loading of an initial value and produces an output "0" upon application of a clock signal and thereafter retains the output "0" no matter how many clock signals are applied.

Thus, an embodiment of this invention can provide for improvement of the operating frequency of a programmable counter circuit which serves as an N-step counter by loading an initial value N. Load terminals of flip-flops of respective stages forming the counter circuit are sequentially cascade-connected via buffers and a load signal is applied to each of the load terminals from a load signal generator circuit. A detector circuit detects a specified value which is provided a little before initial value loading of the counter circuit is to be begun. The detected output is shifted by a shift register which operates on the same clock signals as those for driving the counter circuit, thereby to generate the load signal at the moment at which initial value loading of the counter circuit is to be begun. For the duration of the load signal and a certain period of time subsequent thereto the application of the output from the detector circuit to the shift register is inhibited, thus preventing erroneous loading.

## Claims

1. A programmable counter circuit in which, for loading an initial value (N), a load signal (LOAD) is applied from a load signal generator (LDG) via a load signal line ($L_1$) to each flip-flop stage ($P_{D1}$ to $P_{D12}$) of a counter which serves as an N-step counter dependent on the initial value (N) to be loaded, and in which the load signal generator (LDG) comprises a detector circuit (DET) for detecting a specified count value occurring a little before loading of the initial value into the counter circuit is to be effected, and a shift register (SHR) to which an output provided from the detector circuit (DET) upon detection of the specified value is delivered and through which that output is shifted in response to clock signals ($F_{IN}$), the same as those employed for driving the counter circuit, and which generates the load signal (LOAD) at the moment at which initial value loading of the counter circuit is to be effected, characterised in that the load signal is applied by buffer circuitry

(BUF) comprising a plurality of waveform-shaping buffers (BUF) distributed along the load signal line ($L_1$), and that a load control circuit (LCT) is provided which sends out a signal ($\overline{Q}_5'$) for preventing the delivery of the said output from the detector circuit (DET) to the shift register (SHR) for the duration of the load signal (LOAD) and at least until the loading of a digit of the initial value into the counter circuit making a count value higher than said specified count value.

2. A programmable counter circuit as claimed in claim 1, wherein the load control circuit (LCT) is clocked by the output from one of the flip-flop stages (e.g. $P_{D3}$) of the counter and provides the signal for preventing the delivery of the said output from the detection circuit (DET) to the shift register (SHR) in dependence upon such clocking.

3. A programmable counter circuit as claimed in claim 2, wherein the load control circuit (LCT) comprises a first flip-flop ($P_{D13}$) to which the output from one of the flip-flop stages (e.g. $P_{D3}$) of the counter is applied as a clock signal to invert the first flip-flop which is arranged to be set at a timing a little delayed behind the load signal (LOAD), and a second flip-flop ($P_{D14}$) to which the output from the first flip-flop ($P_{D13}$) is applied as a clock signal and which is arranged to be set by the load signal (LOAD) and, after being reset by a next following clock signal from the first flip-flop ($P_{D13}$), retains its reset state, and wherein the input to the shift register (SHR) is inhibited by the output from the second flip-flop ($P_{D14}$).

4. A programmable counter circuit as claimed in claim 3, wherein the second flip-flop ($P_{D14}$) is formed of a C-MOS flip-flop circuit (Figure 10) which has one of its inputs connected to a high potential power supply ($V_{DD}$) and the other input connected to a low potential power supply ($V_{SS}$) and has no feedback route from its output ($Q_5'$) to its invert input terminal ($\overline{Q}_4'$).

**Revendications**

1. Circuit de comptage programmable dans lequel, pour charger une valeur initiale (N), un signal de chargement (CHARGER) est appliqué, à partir d'un générateur de signaux de chargement (LDG) et par l'intermédiaire d'une ligne de signal de chargement ($L_1$), à chaque étage de bascule ($P_{D1}$ à $P_{D12}$) d'un compteur qui sert de compteur à N pas en fonction de la valeur initiale (N) à charger, et dans lequel le générateur de signaux de chargement (LDG) comprend un circuit détecteur (DET) pour détecter une valeur de comptage spécifiée se produisant un peu avant que le chargement de la valeur initiale dans le circuit de comptage doive être effectué, et un registre à décalage (SHR) auquel est délivré un signal de sortie du circuit détecteur (DET) lors de la détection de la valeur spécifiée et à travers lequel le signal de sortie est décalé en réponse à des signaux d'horloge ($F_{IN}$), qui sont les mêmes que ceux utilisés pour commander le circuit de comptage, et qui engendre le signal de chargement (CHARGER) au moment où le chargement de la valeur initiale dans le circuit de comptage doit être effectué, caractérisé en ce que le signal de chargement est appliqué par un circuit à tampons (BUF) comprenant un ensemble de tampons de mise en forme de forme d'onde (BUF) répartis le long de la ligne de signal de chargement ($L_1$), et en ce qu'un circuit de commande de chargement (LCT) est prévu pour émettre un signal ($\overline{Q_5'}$) afin d'empêcher la délivrance dudit signal de sortie du circuit détecteur (DET) au registre à décalage (SHR) pendant la durée du signal de chargement (CHARGER) et au moins jusqu'à ce que le chargement d'un chiffre de la valeur initiale dans le circuit de comptage rende une valeur de comptage supérieure à la valeur de comptage spécifiée.

2. Circuit de comptage programmable selon la revendication 1, caractérisé en ce que le circuit de commande de chargement (LCT) est synchronisé par le signal de sortie d'un des étages de bascules (par exemple $P_{D3}$) du compteur et fournit le signal pour empêcher la délivrance du signal de sortie du circuit détecteur (DET) au registre à décalage (SHR) en fonction de cette synchronisation.

3. Circuit de comptage programmable selon la revendication 2, caractérisé en ce que le circuit de commande de chargement (LCT) comprend une première bascule ($P_{D13}$) à laquelle est appliqué le signal de sortie d'un des étages de bascules (par exemple $P_{D3}$) du compteur comme un signal d'horloge pour inverser la première bascule qui est agencée pour être positionnée à un temps de synchronisation un peu retardé par rapport au signal de chargement (CHARGER), et une second bascule ($P_{D14}$) à laquelle est appliqué le signal de sortie de la première bascule ($P_{D13}$) comme un signal d'horloge et qui est agencée pour être positionnée par le signal de chargement (CHARGER) et qui, après avoir été remise à l'état initial par un signal d'horloge suivant voisin provenant de la première bascule ($P_{D13}$), maintient sont état initial, et en ce que l'entrée du registre à décalage (SHR) est interdite par le signal de sortie de la second bascule ($P_{D14}$).

4. Circuit de comptage programmable selon la revendication 3, caractérisé en ce que la seconde bascule ($P_{D14}$) est constituée par un circuit à bascule du type à métal-oxyde-semiconducteur à symétrie complémentaire (C-MOS) (Figure 10) qui a une de ses entrées connectée à une source de tension d'alimentation élevée ($V_{DD}$) et l'autre entrée connectée à une source de tension d'alimentation faible ($V_{SS}$) et qui ne comporte pas de chemin de réaction de sa sortie ($Q_5'$) à sa borne d'entrée d'in version ($\overline{Q_4'}$).

**Patentansprüche**

1. Programmierbare Zählschaltung, bei welcher zum Laden eines anfänglichen Wertes (N), ein Ladesignal (LOAD) von einem Ladesignalgenerator (LDG) über eine Ladesignalleitung ($L_1$) zu einer Flipflopstufe (PD1 bis PD12) eines Zählers zugeführt wird, der als N-Stufen-Zähler dient, abhängig von dem anfänglichen Wert (N), der

geladen werden soll, und bei welchem der Signalgenerator (LDG) eine Detektorschaltung (DET) zum Erkennen eines spezifizierten Zählwertes umfaßt, der kurz bevor die Ladung des anfänglichen Wertes in die Zählschaltung bewirkt werden soll auftritt, und ein Schieberegister (SHR), dem ein Ausgangszeichen geliefert wird, welches von der Detektorschaltung (DET) beim Erkennen des spezifizierten Wertes erzeugt wird, und durch welches das Ausgangszeichen in Abhängigkeit von denselben Taktsignalen (FIN), die zum Treiben der Zählschaltung verwendet werden, verschoben wird, und welche das Ladesignal (LOAD) in einem Moment erzeugt, in dem die anfängliche Ladung des Wertes der Zählschaltung durchgeführt wird, dadurch gekennzeichnet, daß das Ladesignal durch eine Pufferschaltung (BUF) angewendet wird, welche eine Anzahl von wellenformenden Puffern (BUF) umfaßt, die längs einer Ladesignalleitung ($L_1$) angeordnet sind, und daß eine Ladesteuerschaltung (LCT) vorgesehen ist, welche ein Signal ($\bar{Q}_5'$) aussendet, zur Verhinderung der Lieferung des genannten Ausgangs von der Detektorschaltung (DET) zu dem Schieberegister (SHR) während der Dauer des Ladesignals (LOAD) und wenigstens bis zur Ladung einer Stelle des anfänglichen Wertes in die Zählschaltung, welche den Zählwert höher als den spezifizierten Zählwert macht.

2. Programmierbare Zählschaltung nach Anspruch 1, bei welcher die Ladesteuerschaltung (LCT) von dem Ausgang von einer der Flipflopstufen (z. B. $P_{D3}$) des Zählers getaktet wird und das Signal zur Verhinderung der Lieferung des genannten Ausgangs von der Detektorschaltung (DET) zu dem Schieberegister (SHR) in Abhängigkeit von solch einer Taktung liefert.

3. Programmierbare Zählschaltung nach Anspruch 2, bei welcher die Ladesteuerschaltung (LCT) ein erstes Flipflop ($P_{D13}$) umfaßt, dem der Ausgang von einer der Flipflopstufen (z. B.: $P_{D3}$) des Zählers als ein Taktsignal zugeführt wird, um das erste Flipflop zu invertieren, welches so angeordnet ist, daß es zu einem Zeitpunkt gesetzt wird, der ein wenig gegenüber dem Ladesignal (LOAD) verzögert ist, und ein zweites Flopflop ($P_{D14}$), dem der Ausgang von dem ersten Flipflop ($P_{D13}$) als ein Taktsignal zugeführt wird und welches so angeordnet ist, daß es durch das Ladesignal (LOAD) gesetzt wird und, nachdem es durch das nächstfolgende Taktsignal von dem ersten Flipflop ($P_{D13}$) zurückgesetzt ist, seinen Rücksetzzustand beibehält, und bei welcher der Eingang zu dem Schieberegister (SHR) durch den Ausgang von dem zweiten Flipflop ($P_{D14}$) gesperrt wird.

4. Programmierbare Zählschaltung nach Anspruch 3, bei welcher das zweite Flipflop ($P_{D14}$) aus einer C-MOS-Flipflopschaltung (Figur 10) gebildet ist, deren einer Eingang mit einer Energieversorgung ($V_{DD}$) hohen Potentials verbunden ist und deren anderer Eingang mit einer Energieversorgung ($V_{SS}$) niedrigeren Potentials verbunden ist, und keinen Rückkopplungsweg von seinem Ausgang ($Q_5'$) zu seinem Umkehreingangsanschluß ($Q_4'$) hat.

FIG.1

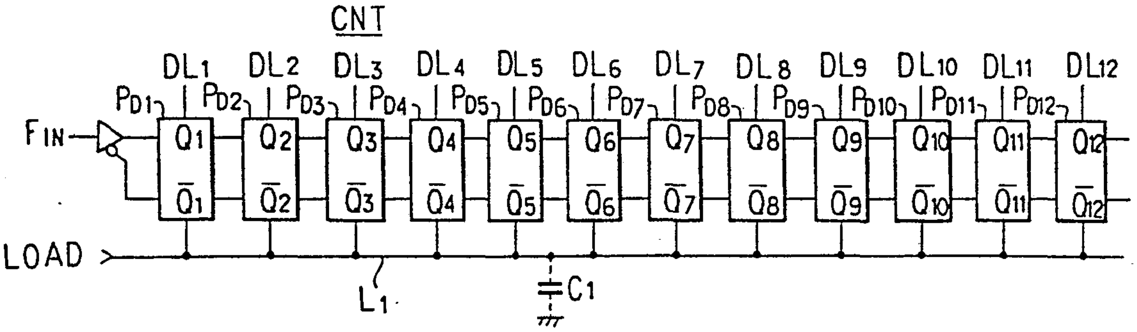


FIG.2

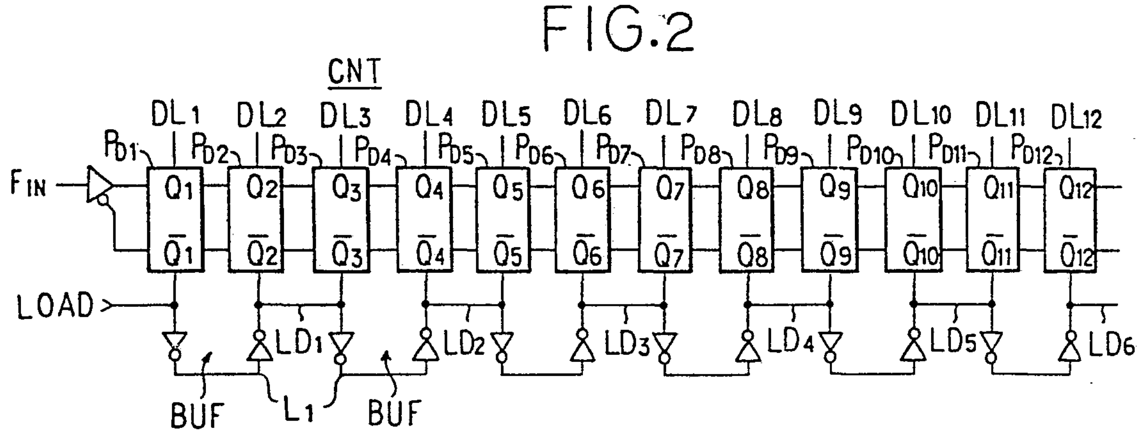


FIG.3

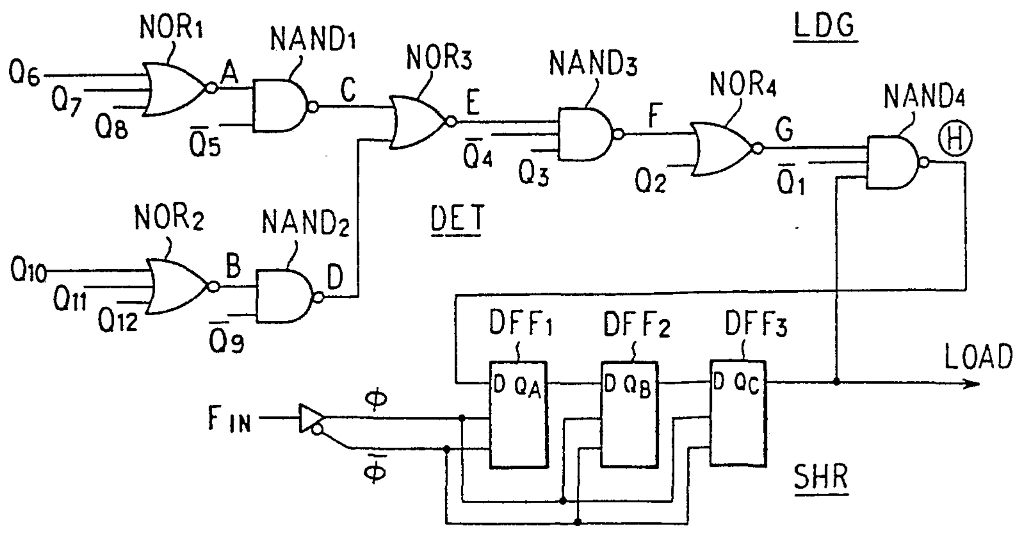

FIG.4

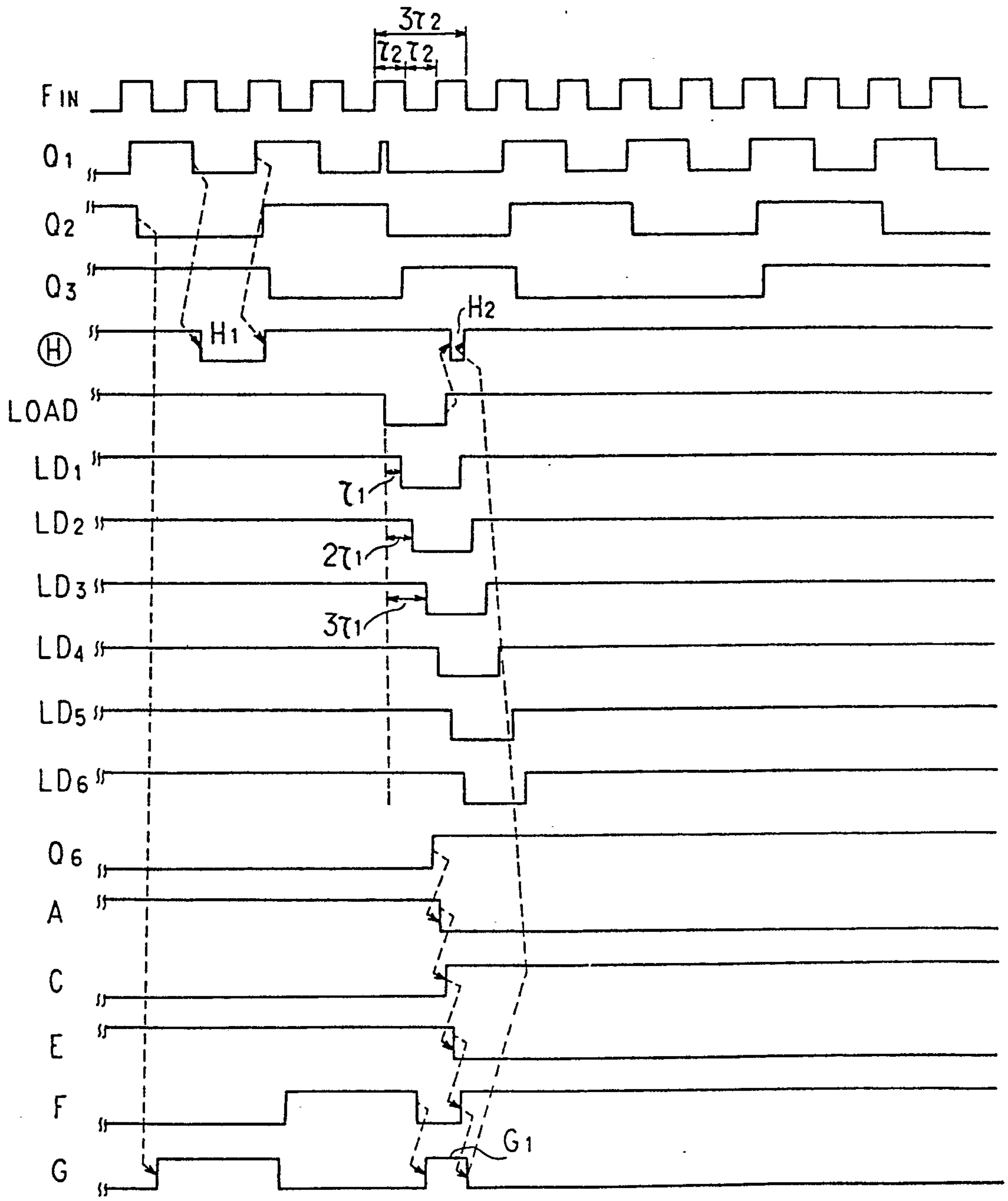
3τ2
τ2 τ2
FIN
Q1
Q2
Q3
H
H1
H2
LOAD
LD1
LD2
LD3
LD4
LD5
LD6
τ1
2τ1
3τ1
Q6
A
C
E
F
G
G1

FIG.5

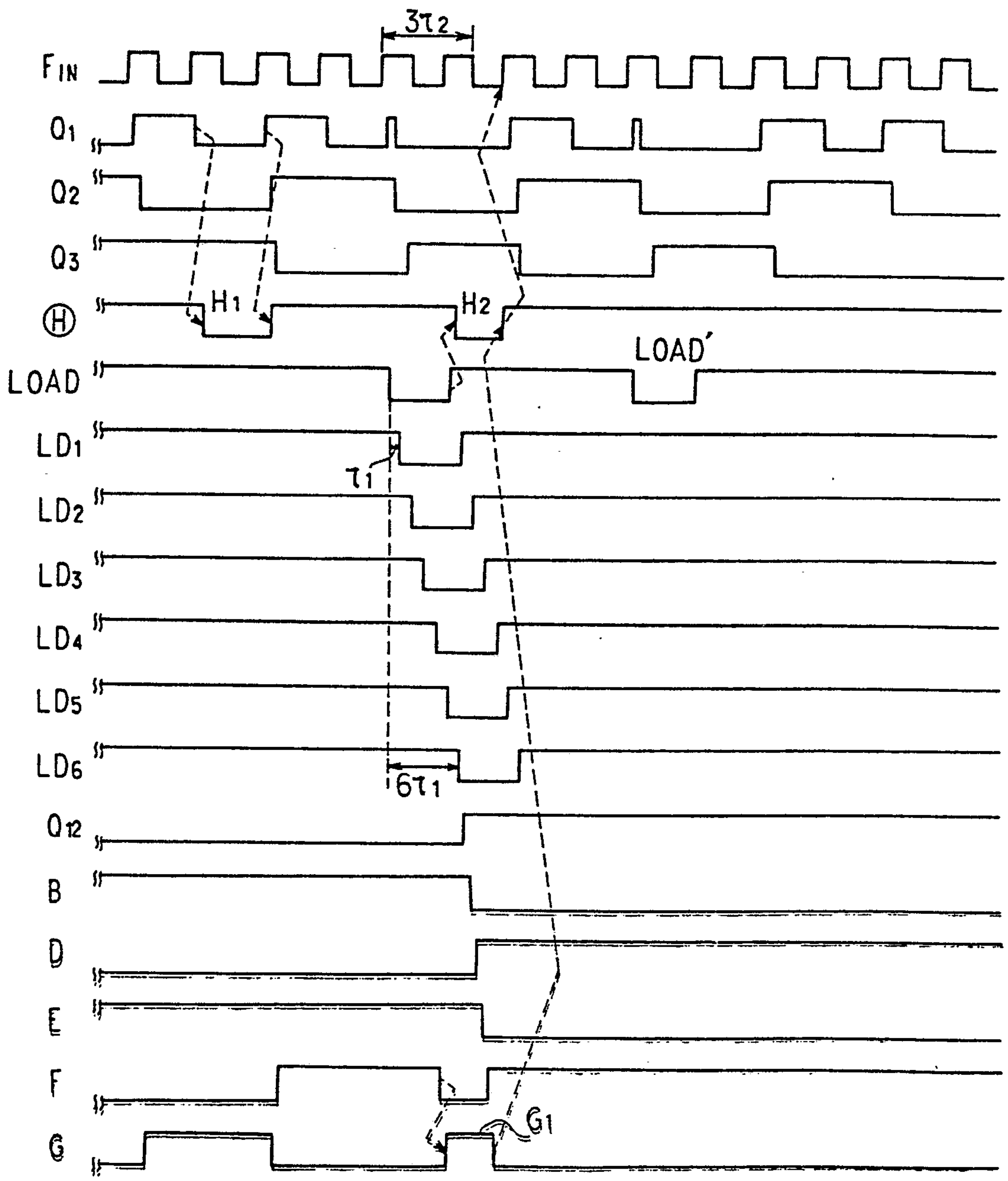
3τ2
F_IN
Q1
Q2
Q3
Ⓗ
H1
H2
LOAD
LOAD′
LD1
τ1
LD2
LD3
LD4
LD5
LD6
6τ1
Q12
B
D
E
F
G
G1

FIG.6

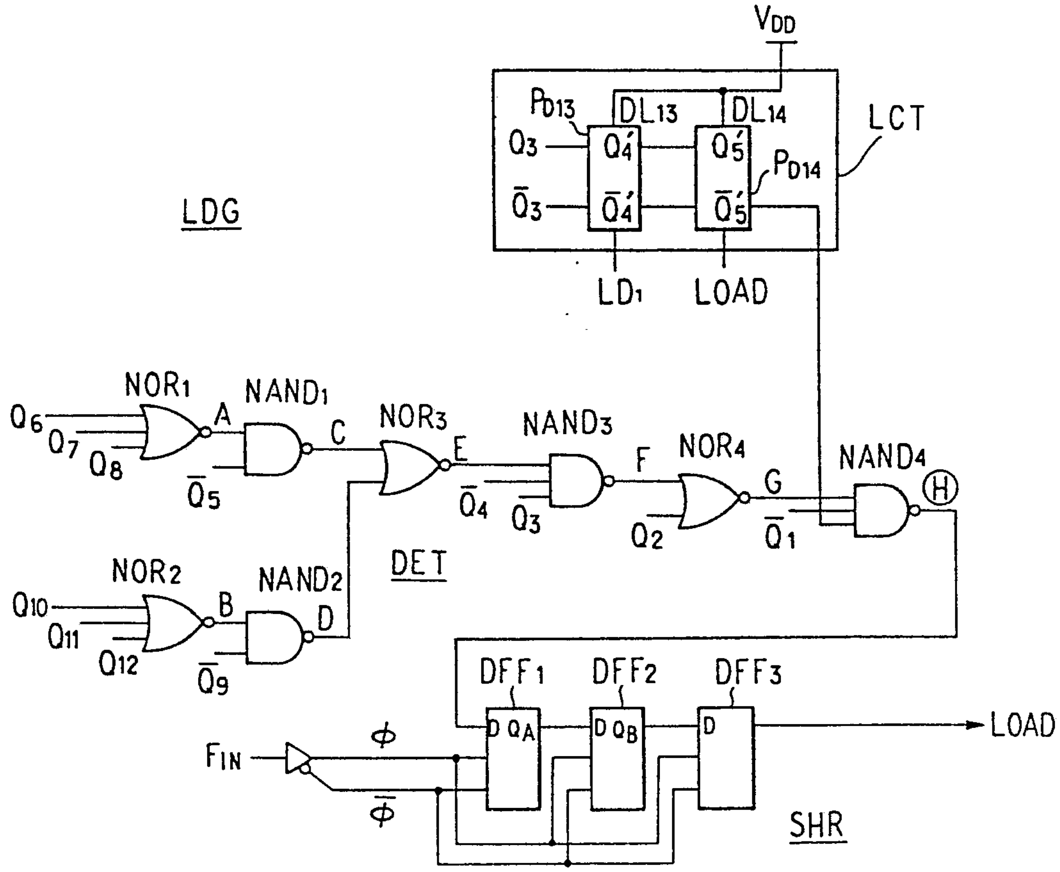

VDD
PD13
DL13
DL14
LCT
Q3
Q̄3
Q4'
Q̄4'
Q5'
Q̄5'
PD14
LD1
LOAD
LDG
NOR1
NAND1
NOR3
NAND3
NOR4
NAND4
Q6
Q7
Q8
A
C
E
F
G
H
Q̄5
Q̄4
Q3
Q2
Q̄1
DET
NOR2
NAND2
Q10
Q11
Q12
B
D
Q̄9
DFF1
DFF2
DFF3
D QA
D QB
D
LOAD
FIN
Φ
Φ̄
SHR

FIG.7

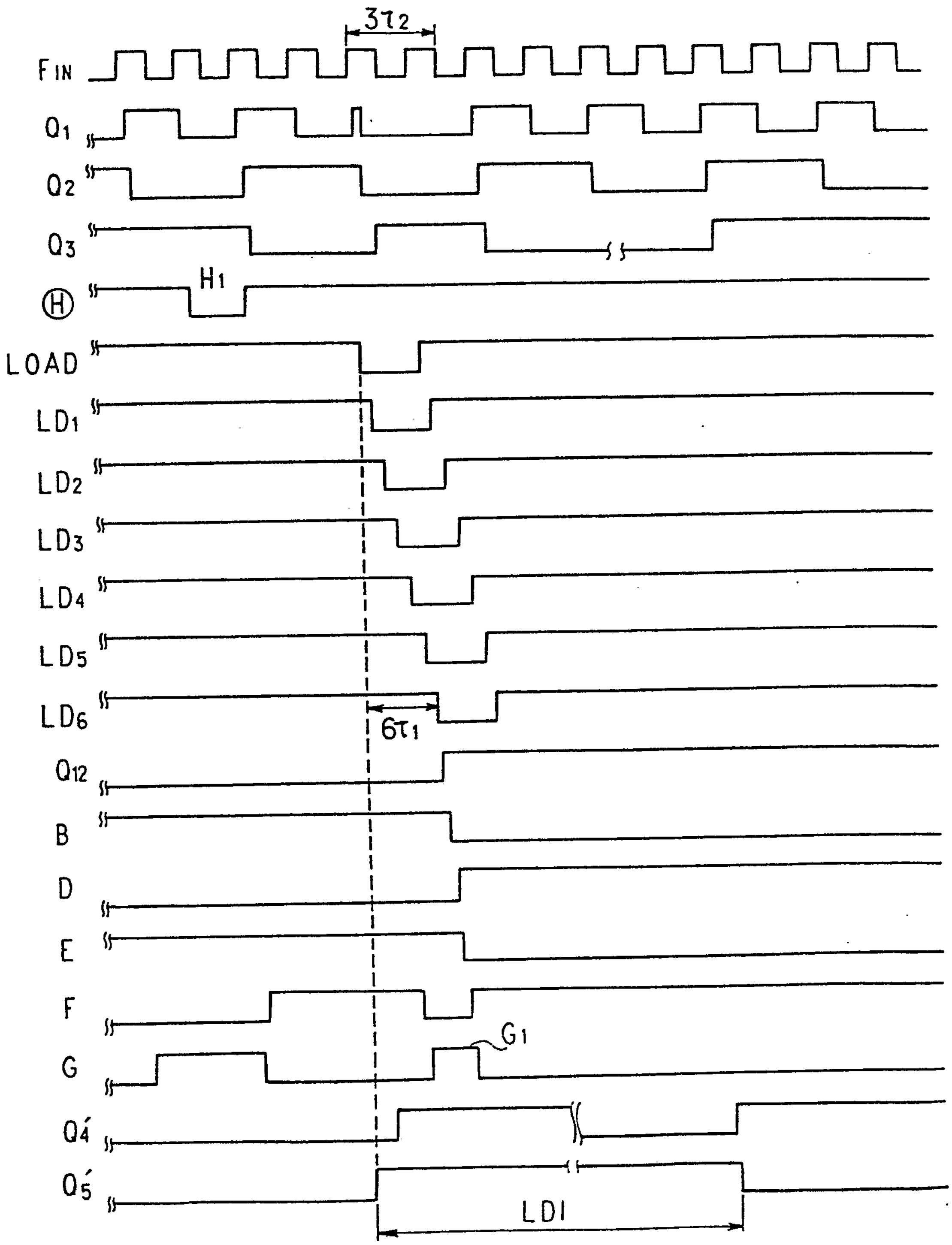
3τ2
FIN
Q1
Q2
Q3
H
H1
LOAD
LD1
LD2
LD3
LD4
LD5
LD6
6τ1
Q12
B
D
E
F
G
G1
Q4'
Q5'
LDI

FIG.8

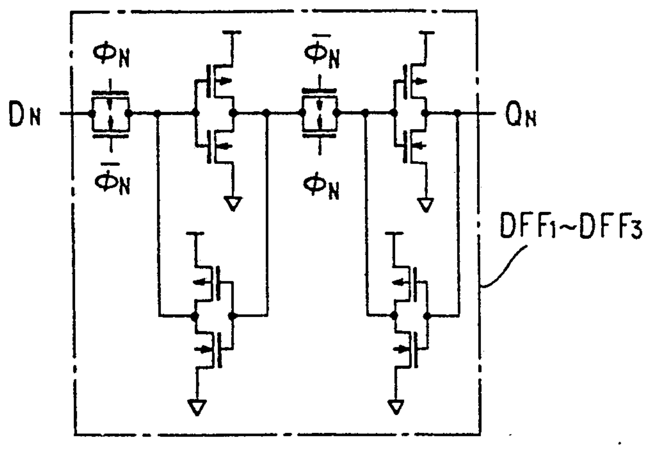


FIG.9

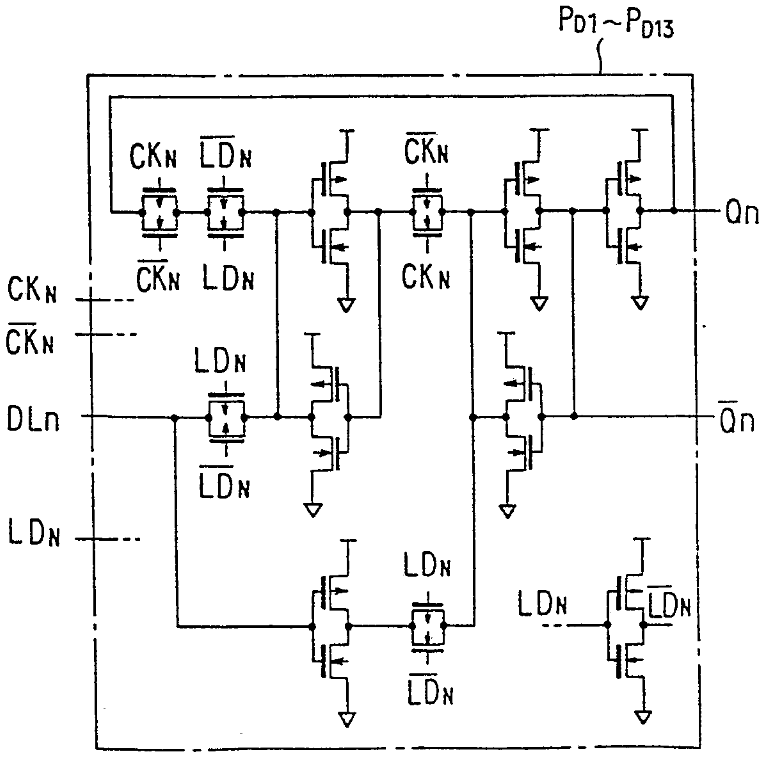

FIG.10

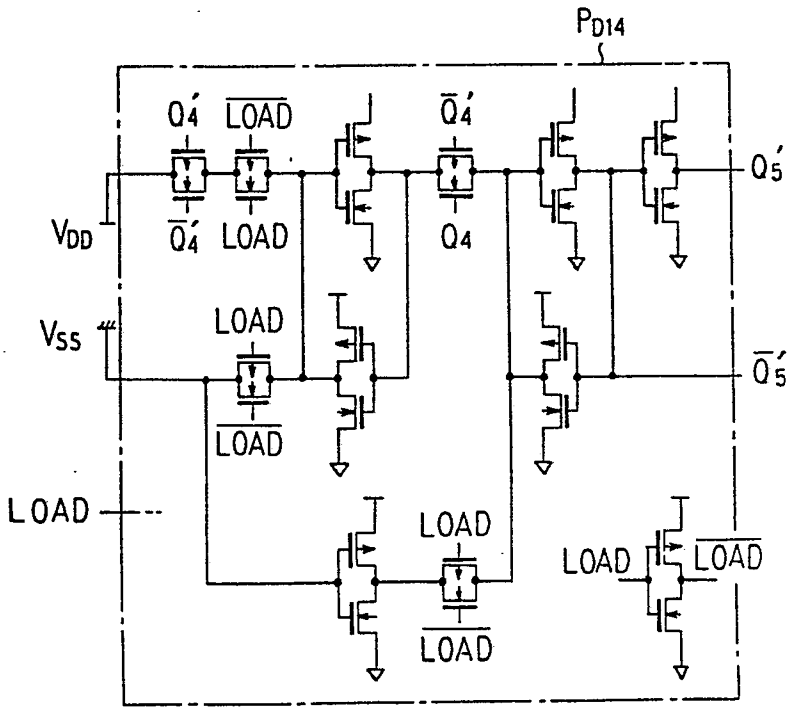
PD14
Q4'
LOAD
Q4'
Q4
Q5'
VDD
Q4'
LOAD
Q4
VSS
LOAD
LOAD
Q5'
LOAD
LOAD
LOAD
LOAD
LOAD
LOAD